# EUROPEAN PATENT SPECIFICATION

(11) **EP 0 363 936 B1**
(45) Date of publication and mention of the grant of the patent: **27.03.1996**
(21) Application number: 89118909.4
(22) Date of filing: 11.10.1989
(51) Int. Cl.: H01L 21/56, H01L 23/31

(54) **Method of manufacturing electric devices**
Verfahren zum Herstellen elektrischer Anordnungen
Procédé pour la fabrication de dispositifs électriques

(30) Priority: 12.10.1988 JP 256701/88; 12.10.1988 JP 256702/88
(43) Date of publication of application: 18.04.1990
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo 157 (JP); Urata, Kazuo, Atsugi-shi Kanagawa-ken 243 (JP); Hirose, Naoki, Atsugi-shi Kanagawa-ken 243 (JP); Koyama, Itaru, Hatano-shi Kanagawa-ken 257 (JP); Imatou, Shinji, Atsugi-shi Kanagawa-ken 243 (JP); Nakashita, Kazuhisa, Atsugi-shi Kanagawa-ken 243 (JP)
(74) Representative: Grünecker, Kinkeldey, Stockmair & Schwanhäusser Anwaltssozietät

(56) References cited:
- GB-A- 2 089 126
- PATENT ABSTRACTS OF JAPAN vol. 10, no. 27 (E-378)(2084) 04 February 1986, & JP-A-60 186 026
- PATENT ABSTRACTS OF JAPAN vol. 9, no. 106 (E-313)(1829) 10 May 1985, & JP-A-59 231 840

## Description

The invention relates to a method of forming an electric device.

Semiconductor integrated circuits are most important electric devices which are widely used in a variety of fields. One of the problems of integrated circuits, however, from the view point of reliability arises from invasion of moisture or other impurities into the IC chips after they have been encapsulated in plastic moulding material, such invasion taking place through cracks or gaps in the encapsulation which form paths from outside of the encapsulation to the surface of the IC chip. Any moisture for example which reaches the IC surface will cause undesirable corrosion of the semiconductor constituting the IC chip and lead to malfunction of the chip.

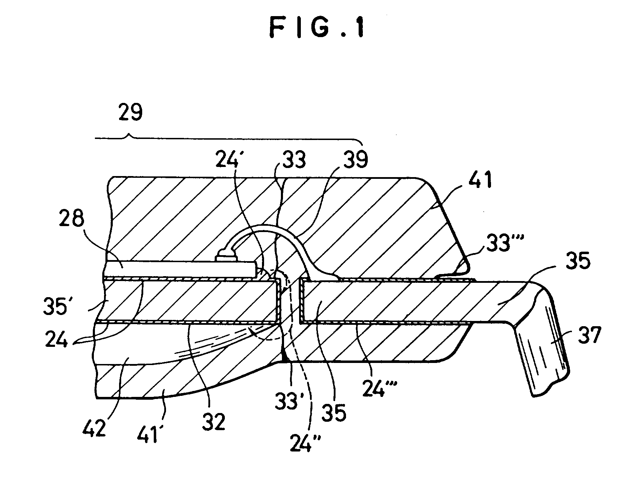

Fig.1 of the accompaning drawings is an illustration showing how defects can be formed in a packaged IC device. The structure comprises an IC semiconductor chip 28 mounted on a base 35', a lead frame with leads 37 with which the termination of the IC chip 28 are electrically coupled by means of Au wiring 39, and epoxy moulding material 41 encapsulating the IC chip and the lead frames. The surface of the base and/or of the lead frame tend to oxidize and form suboxide films and moisture tends to gather near the interface between these layers and the encapsulation. When the IC device is assembled onto an electrical circuit board and, soldering is performed, the IC device is exposed to the temperature of molten solder at 260°C for example for a time period of from 3 to 10 seconds. The IC is thus subjected to a rapid change in temperature which often causes cracks to appear in the encapsulation as designated by 33, 33' and 33". Also, any moisture trapped within the encapsulation will evaporate and cause swelling such as that shown at 41' with cavities 42 being formed by the vapour pressure and resulting in cracks 33'. This swelling is particularly likely since the oxide film 32 weakens the adhesion of the encapsulation to the base 35.

The likelihood of the above problems have been particularly increased when silver paste 24 is used to bond the chip 28 on the base 35. In a prior art method disclosed in GB-A-2 089 126 bonding of the chip is performed by heating at from 100 °C to 220°C in order to cure the paste. During the heating process, organic gas of the vaporized solvent within the paste escapes from the paste 24, particularly from the projected portion 24'. The solvent having a boiling point between 120° and 180°C. Some of the excaping gas is trapped by the external surface of the lead frame and weakens the adhension of the encapsulation to the frame.

It is the object of the invention to provide a method of manufacturing reliable electric devices which is immune to the above problems which as explained can give rise to moisture, organic materials or other impurities invading through cracks or other paths in the encapsulation of prior art device or at least being improved in these respects as compared to the prior art devices.

In order to accomplish the above and other objects and advantages, an electric device having been attached-to a lead frame with an organic adhesive is kept in advance of encapsulation at a pressure not higher than 1.33 Pa (10⁻ Torr), preferably not higher than 0.00133 Pa (10⁻⁵), typically from 0.665 Pa (5 x 10⁻³ Torr) to 1.33 x 10⁻⁶ Pa (1 x 10⁻⁸). Unnecessary gaseous organic material escaped from the organic adhesive and trapped by the surface of the device and the lead frame can be evacuated under such a high vacuum condution. Then the organic material attached on the lead frame is removed by plasma ashing. The plasma ashing is achieved by applying electric energy to an oxidizing ashing agent such as 0₂ or N₂0. By virtue of the oxidizing plasma, organic materials are decomposed into carbon dioxide and water. A plasma cleaning may be carried out to remove oxygen after ashing by use of a cleaning agent such as Ar, Ne, Kr, H₂, N₂ or NH₃. Ar is particularly preferred because it is easy to convert into a plasma. The both ashing and cleaning processes can be performed at pressures from 66.5 Pa (5 x 10⁻¹ Torr) to 0.133 Pa (10⁻³), preferably from 13.3 Pa (10⁻¹ Torr) to 0.665 Pa (5 x 10⁻³ Torr). After ashing and cleaning, a protective film such as a silicon nitride film may be deposited to a thickness of from 30 nm (300 angstroms) to 50 nm (500 angstroms).

### BRIEF DESCRIPTION OF THE DRAWING

This invention can be better understood from the following detailed description when read in conjunction with the drawing in which;
Fig.1 as abovementioned is an explanatory cross section illustrating disadvantages of prior art devices.
Fig.2 is a schematic diagram showing a plasma CVD apparatus for use in the practice of the present invention.
Fig.3(A) is a schematic plan view showing a lead frame structure for supporting twelve IC devices, Fig.3(B) is an enlarged view showing one unit of the 12 unit lead frame illustrated in Fig.3(A), and Fig.3(C) is a schematic view showing how multiple lead frames may be supported in jigs.
Fig.4 is a cross section showing part of an IC device in accordance with the present invention.
Figs.5(A) to 5(C) are graphical diagrams showing the depth profiles of Si, N, C and 0 in an IC device in accordance with the present invention.

### DETAILED DESCRIPTION OF THE PREFERRED EMBODIMENTS

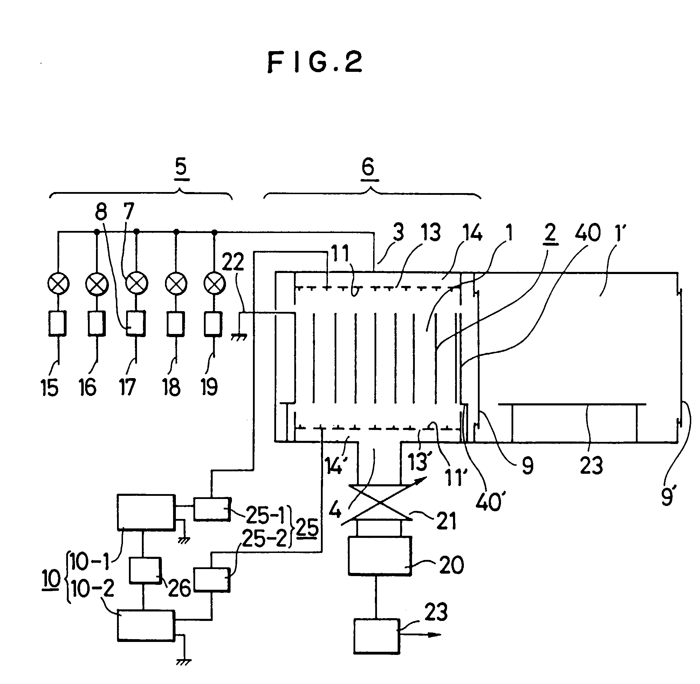

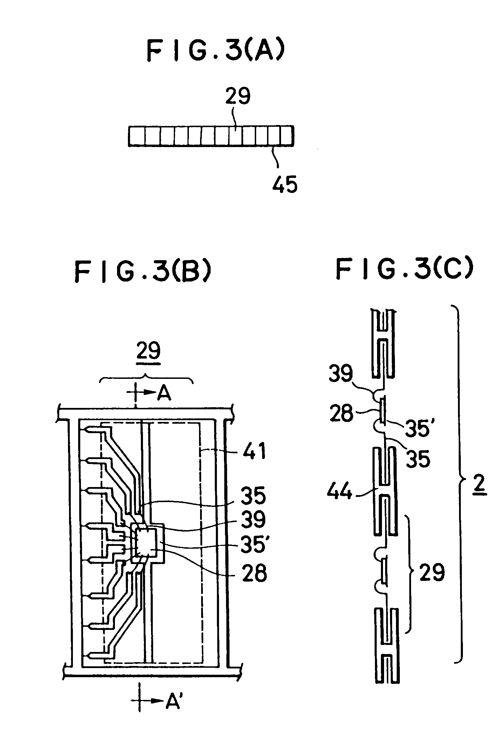

Referring now to Figs.2 and 3(A) to 3(C), a plasma processing method in accordance with an embodiment of the present invention will hereinafter be described. Fig.2 is a schematic cross-sectional diagram showing a plasma CVD apparatus. The apparatus comprises a deposition chamber 1, a loading-unloading chamber 1' coupled to the deposition chamber 1 through a gate valve 9, a pair of mesh or grid electrodes 11 and 11' provided in the deposition chamber 1, a gas feeding system 5, an evacuation system comprising a turbo molecular pump 20 and a rotary pump 23 connected to the chamber 1 through a valve 21, a high frequency power source 10-1 for supplying electric energy to the electrode 11 through a matching device 25-1 and a high frequency power source 10-2 for supplying electric energy to the electrode 11' through a matching device 25-2. The differential phase between the power sources 10-1 and 10-2 can be controlled by means of a phase adjuster 26 to be 180° + 30° or 0° + 30°. The gas feeding system includes five sets of flow rate meters 7 and valves 8. The high frequency energy inputted to the electrodes 11 and 11' causes positive column glow discharge therebetween. The glow discharge region (deposition region) is confined by a four-sided frame 40 in order to avoid undesirable deposition outside the region. The frame 40 is supported by a support means 40' and may be a grounded metal frame or an insulating frame. Within the deposition region, a number of IC chip carriers 2 are supported by the frame 40 and are disposed in parallel with each other and spaced apart by intervals of from 2 to 13 cm, e.g. 6 cm. A plurality of IC chips are mounted on each carrier 2.

The chip carriers are comprised of holding jigs 44 which serve to support lead frames 29 interposed between and supported by the adjacent jigs 44 as illustrated in Fig 3(C). IC chips are bonded by means of silver paste to appropriate parts (center bases) of the several units making up the lead frame 29 and are electrically connected to the ends 35 of the leads of the lead frames arranged therearound by means of Au wiring 39. The silver paste is composed of silver fine powder and organic fluid carrying the powder. Fig.3(B) shows one unit of the lead frame 29 and as can be seen each unit is provided with the leads necessary for one IC chip package as defined by broken line 41; illustration of the leads on the right hand side of the chip package is dispensed with in the figure. This unit structure is repeated along the length of the lead frame 29 between the upper and lower rails of the lead frame as is schematically shown in Fig.3(A). One lead frame 29 may contain from 5 to 25 unit structures as exemplified by the lead frame of Fig.3 which has 12 units. A number of the jigs 44 may be integrally assembled in order to support 10 to 50 of the lead frames 29 therebetween as shown schematically shown in Fig.3(C) where the lead frames 29 are supported in grooves in the jigs 44; alternatively, the lead frames 29 could be suspended at holes by pins (not shown) formed on the jigs.

Next, the provision of a protective film coating on the IC chips will be explained. First, a number of lead frames are mounted on the carriers 2 after completing the electrical connection between the chips and the associated leads of the lead frames. The carriers are then introduced in the deposition chamber at a constant spacing from each other through the loading-unloading chamber 1'.

In advance of actual deposition of the protective film, the external surfaces of the IC devices are cleaned. In particular, organic materials and suboxide films are removed from the IC surfaces. First, unnecessary gaseous organic material which escaped from the Ag paste is exhausted by evacuating the deposition chamber and keeping the carriers at from 0.133 Pa (10⁻³ Torr) to 1.33 x 10⁻⁶ Pa (1 x 10⁻⁸ Torr), preferably from 1.33 x 10⁻³ to 1.33 x 10⁻⁶ Pa (1 x 10⁻⁵ to 1 x 10⁻⁸ Torr. Then, N₂O is admitted to the deposition chamber 1 at 6.65 Pa (5 x 10⁻ Torr) from the gas feeding system through a nozzle 3. The ashing gas is then converted into an oxidizing plasma by inputting energy of 1 KW at 13.56 MHz in order to establish a glow discharge in the chamber 1, and plasma ashing of the IC chips is effected for from 5 to 15 minutes. By virtue of this ashing, organic material attached on the surfaces of the lead frames are eliminated. Next, Ar gas is admitted to the deposition chamber 1 at 1.33 to 133 Pa (0.01 to 1 Torr) from the gas feeding system through the nozzle 3. The Ar gas is then converted into its plasma state by inputting energy of 1 KW at 13.56 MHz in order to establish a glow discharge in the chamber 1, and plasma cleaning of the IC chips is effected for from 10 to 30 minutes. By virtue of this cleaning, suboxide films coated on the surfaces of the lead frames are eliminated. Then, the surfaces of the carriers have been cleaned. In addition to Ar, 5-30 % of H₂ may be introduced. Next, NH₃, Si₂H₆ and N₂ are leaked through the nozzle 3 at 1.33 to 133 Pa (0.01 to 1 Torr) into the deposition chamber 1 respectively from introduction ports 15, 16 and 17 at appropriate pressures. The introduction molar ratio of NH₃/Si₂H₆/N₂ is 1/3/5. Alternatively, the reactive gas can be composed of Si₂H₆ and N₂ in a ratio of 1:5 instead. Positive column glow discharge takes place when high frequency energy is input to the pair of electrodes 11 and 11' at 1 KW and from 1 to 500 MHz, e.g. 13.56 MHz. As a result, a silicon nitride coating is deposited on the chips, on the leads and on the connections therebetween. The thickness of the coating can reach from 20 to 200 nm (200 to 2000 angstroms), e.g. 100 ± 20 nm (1000 ± 200 angstroms), if the deposition is continued for 10 minutes. The average deposition speed is about 0.3 nm/s (3 angstrom/sec). During the deposition, the carrier is not particularly heated.

After completing the deposition, the carriers 2 are removed from the chamber and undergo an encapsulation process. Each carrier is placed in a moulding apparatus just as it is. By use of appropriate moulding dies, an epoxy material (410A) is injected around each chip to encapsulate the chips and form the external chip packages. After removing the carriers from the moulding apparatus, the IC's are separated from the lead frames by severing the leads. Each lead, which extends beyond the encapsulation, is then bent downwardly in order to form the legs of the IC package. The leads are cleaned by acid washing, and are then subjected to solder plating.

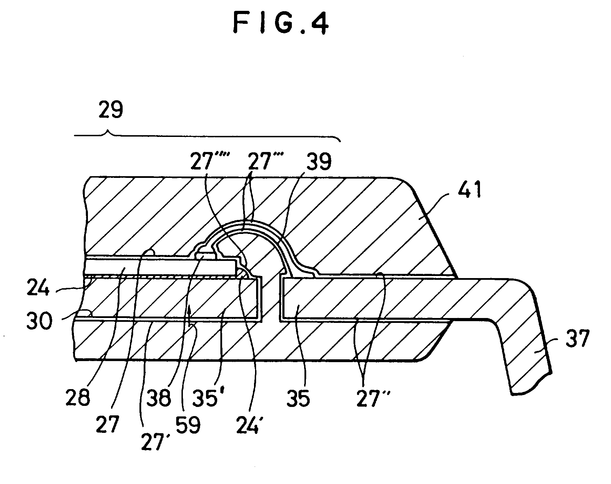

The structure of the wiring connections in an IC chip in accordance with the present invention is illustrated in Fig.4. As shown, a protective film 27,27',27",27''',27'''' of silicon nitride covers the surfaces of the IC chip mounted on the base 35', the contacts 38, the Au wiring 39 and the leads 37 made of alloy. By virtue of the provision of this protective coating on the surfaces which have been cleaned in advance, the chip is protected from attack by moisture which may invade the chip encapsulation through cracks or gaps as was explained with reference to Fig.1. The reliability of the mechanical connection between the lead frames and the silicon nitride film is ensured by virtue of the surfaces of the lead frames being plasma ashed and cleaned in advance of the silicon nitride film deposition.

In accordance with experiments that we have conducted, the IR absorption spectrum of the deposited films showed a peak at 864 cm⁻¹ which is indicative of Si-N bondings. The withstand voltage level of the insulating coating was measured to be 7 x 10⁶ V/cm or higher. The resistivity of the coating was measured to be 2 x 10⁵ ohm centimeter. The reflective index of the coating is measured to be 2.0. The protection ability of the coating was evaluated by subjecting it to HF etching. The etching speed was from 3 to 10 angstroms/sec, which was substantially small as compared to the figure, about 30 angstroms/sec, of conventional silicon nitride coatings. Protection of an IC by means of such an excellent coating may be achieved by a coating of 100nm (1000 angstroms) ((30 to 500 nm 300 to 5000 angstroms) in general).

IC devices manufactured in accordance with the present invention were kept in 5% NaCl solution at 95°C for 20 hours and no appreciable change was detected. Also, IC devices manufactured in accordance with the present invention were subjected to PCT (pressure cooker test) under 2 atmospheres at 120°C for 20 hours and no defective IC's were found after the test. As compared to prior art IC's the fraction that was defective was decreased from 50 - 100 fits to 5 - 10 fits; one fit means 10⁻⁸.

After being kept in an atmosphere of 85°C and 85% relative humidity for 1000 hours, IC devices ashed, cleaned and coated in accordance with the present invention were exposed to molten solder at 260°C for 3 seconds in order to make electrical connection with circuits on a circuit board; no cracks or no swellings appeared.

300 samples were prepared under diverse preparation conditions. These samples were kept in an atmosphere of 85°C and 85% relative humidity for 1000 hours and subjected to a reliability test. The reliability test was carried out by heating at 260°C for 3 seconds. The results are shown in the following table.

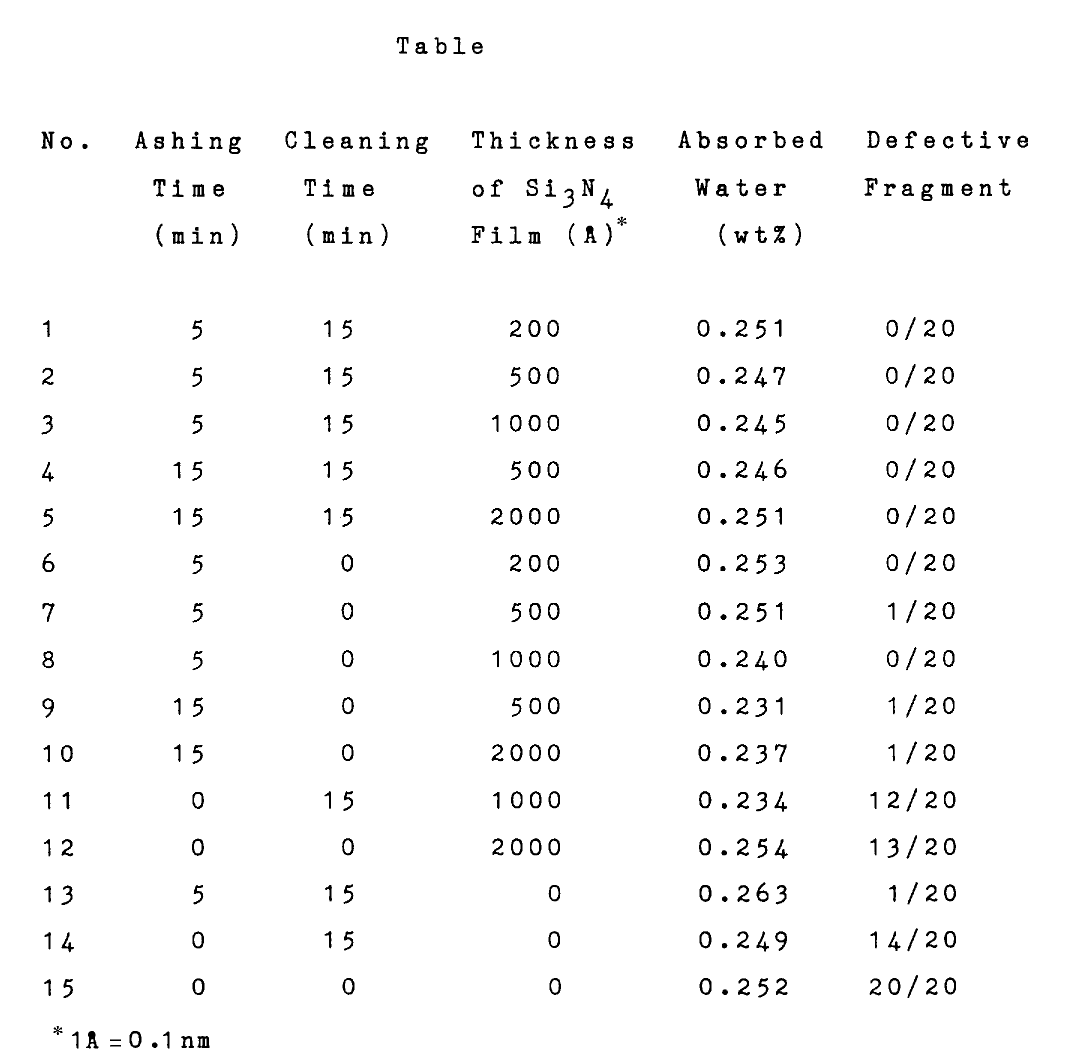

As can be seen from the above table, when ashing, cleaning and deposition were carried out, no defective IC was produced (Nos. 1 to 5). Even when ashing and deposition were carried out and cleaning was dispensed with, only three samples were found to be defective out of 100 samples (Nos.6 to 10). When ashing was not carried out, many defective IC's were produced even if cleaning and/or deposition was performed (Nos.11, 12, 14 and 15). Even if deposition was not carried out, only one defective IC was formed when both ashing and cleaning were carried out (No.13).

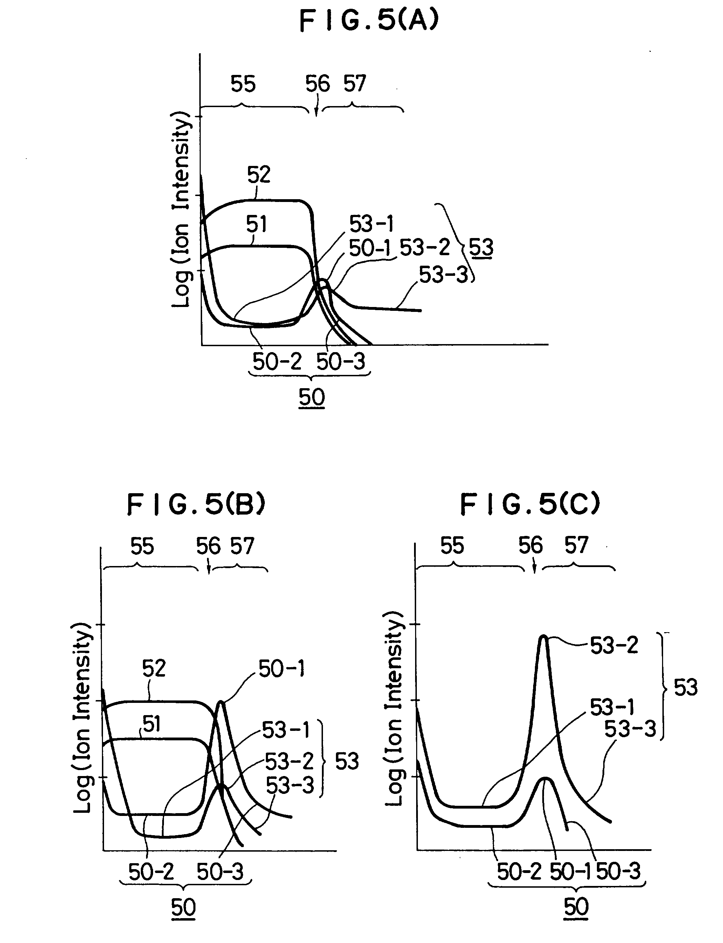

Figs.5(A) to 5(C) are graphical diagrams showing molecular spectra which were obtained by use of SIMS (Secondary Ion Mass Spectrometry) along the depth direction of the surfaces of the sample IC's. In the diagrams, curves 51, 52 and 53 designate the depth profiles of Si ions, N ions and 0 ions, respectively. Region 55 corresponds to the thickness of the silicon nitride film, region 56 to interface between the silicon nitride film and the underlying frame and region 57 to the underlying frame. Fig.5 (A) shows the spectra of the No.5 IC. The effects of plasma ashing and cleaning are apparent from the fact that the density of carbon atoms at the interface can be assumed not higher than 2 x 10⁻⁰ cm⁻³, typically not higher than 7 x 10⁻¹⁹ cm⁻³ from curve 50 and the density of oxygen atoms can also be assumed not higher than 2 x 10⁻⁰ cm⁻³ from curve 53. Fig.5 (B) shows the depth profile of the No.12. The density of carbon was particularly high at the interface as assumed to be from 3 x 10⁰ to 2 x 10¹ cm-³. Fig.5 (C) shows the depth profile of the No.7. The oxygen density was particularly high at the interface as assumed to be 3 x 10⁰ to 1 x 10¹ cm⁻³. The oxygen atoms had got mixed into the silicon nitride film which as a result was converted to rather oxynitride. The carbon density in turn was decreased in light of the ashing process to be not higher than 2 x 10⁰ cm⁻³, typically 1-7 x 10¹⁹ cm⁻³.

Diamond like carbon, silicon oxide or other insulating material can be deposited to form the protective coating. Although the embodiment was IC chips, the method can be applied to other electric devices, such as resistors and capacitors. Also, the present method is effective in case utilizing other bonding steps such as flip chip bonding and solder bump bonding.

The plasma cleaning can be made more effective when the plasma is energized further by illumination of IR light rays having wavelengths of 10 to 15 micrometers or UV light rays having wavelengths no longer than 300 nanometers.

In the above embodiment, the lead frames are of the dual-in-line type. However, the present method can be applied to other types of lead frames such as the flat pack type.

## Claims

1. A method of forming electrical devices encapsulated by an epoxy moulding material, said method comprising the succeeding steps of;
a) mounting an electric device (28) on a lead frame (29) by means of an organic conductive adhesive (24);
b) making an electric connection between said electric device (28) and said lead frame (29);
c) placing said electric device (28) mounted on said lead frame into a vacuum chamber (1);
d) evacuating said vacuum chamber to a pressure not higher than 1.33 Pa(10⁻ Torr) in order to remove vaporized gas of said organic conductive adhesive ;
e) introducing an oxidizing ashing agent gas into said vacuum chamber (1);
f) supplying electric energy to said oxidizing ashing agent gas in order to form an oxidizing plasma which decomposes organic material attached to said lead frame (29) into carbondioxide and water;
g) removing said electric device (28) mounted on said lead frame (29) from said vacuum chamber (1); and
h) encapsulating said electric device (28) with said epoxy moulding material.

2. Method of claim 1 wherein said oxidizing ashing agent gas is O₂ or N₂O.

3. Method according to claims 1 or 2, wherein it comprises the step of plasma cleaning said electric device (28) mounted on said lead frame (29) with a cleaning agent after step f) and prior to step g).

4. Method according to claim 3, wherein said cleaning agent is Ar, Ne, Kr, H₂, N₂ or NH₃.

5. Method according to one of claims 3 or 4, wherein a protective film is deposited on said electric device (28) and said lead frame (29) after said plasma cleaning and prior to said removing from the vacuum chamber (1).

## Patentansprüche

1. Verfahren zum Herstellen elektrischer Anordnungen, die von einem Epoxydgießmaterial eingeschlossen sind, wobei das Verfahren die aufeinanderfolgenden Schritte aufweist:
a) Anbringen einer elektrischen Anordnung (28) auf einem Leiterrahmen (29) mit Hilfe eines organischen leitenden Klebers (24);
b) Herstellen einer elektrischen Verbindung zwischen der elektrischen Anordnung (28) und dem Leiterrahmen (29);
c) Bringen der auf dem Leiterrahmen angebrachten elektrischen Anordnung (28) in eine Vakuumkammer (1);
d) Evakuieren der Vakuumkammer auf einen Druck nicht höher als 1,33 Pa(10⁻ Torr), um verdampftes Gas des organischen leitenden Klebers zu entfernen;
e) Einführen eines oxidierenden Verbrennungsreagenzgases in die Vakuumkammer (1);
f) Entfernen der auf dem Leiterrahmen (29) aufgebrachten elektrischen Anordnung aus der Vakuumkammer (1), und
h) Einschließen der elektrischen Anordnung (28) mit dem Epoxydgießmaterial.

2. Verfahren nach Anspruch 1, wobei das oxidierende Verbrennungsreagenzgas O₂ oder N₂O ist.

3. Verfahren nach Anspruch 1 oder 2, wobei es den Schritt einer Plasmareinigung der auf dem Leiterrahmen (29) aufgebrachten elektrischen Anordnung (28) mit einem Reinigungsreagenz nach dem Schritt f) und vor dem Schritt g) aufweist.

4. Verfahren nach Anspruch 3, wobei das Reinigungsreagenz Ar, Ne, Kr, H₂, N₂ oder NH₃ ist.

5. Verfahren nach Anspruch 3 oder 4, wobei ein Schutzfilm auf der elektrischen Anordnung (28) und dem Leiterrahmen (29) nach dem Plasmareinigen und vor dem Entfernen aus der Vakuumkammer (1) abgelagert wird.

## Revendications

1. Procédé pour la formation de dispositifs électriques enrobés d'un matériau à mouler époxyde, ledit procédé comprenant les étapes successives consistant à:
a) monter un dispositif électrique (28) sur un ensemble de connexions externes en cadre (29) à l'aide d'un adhésif conducteur organique (24),
b) réaliser une connexion électrique entre ledit dispositif électrique (28) et ledit ensemble de connexions externes en cadre (29),
c) placer ledit dispositif électrique (28), monté sur ledit ensemble de connexions externes en cadre, dans une chambre à vide (1),
d) évacuer ladite chambre à vide à une pression non supérieure à 1,33 Pa (10⁻ Torrs), afin d'éliminer le gaz vaporisé dudit adhésif conducteur organique,
e) introduire un gaz de calcinage oxydant dans ladite chambre à vide (1),
f) alimenter une énergie électrique vers ledit gaz de calcinage oxydant, afin de former un plasma oxydant qui décompose les matières organiques fixées audit ensemble de connexions externes en cadre (29) en dioxyde de carbone et en eau,
g) enlever ledit dispositif électrique (28), monté sur ledit ensemble de connexions externes en cadre (29), de ladite chambre à vide (1), et
h) enrober ledit dispositif électrique (28) dudit matériau à mouler époxyde.

2. Procédé suivant la revendication 1, dans lequel ledit gaz de calcinage oxydant est O₂ ou N₂O.

3. Procédé suivant la revendication 1 ou 2, dans lequel il comprend l'étape consistant à nettoyer au plasma ledit dispositif électrique (28) monté sur ledit ensemble de connexions externes en cadre (29) à l'aide d'un agent de rinçage, après l'étape f) et avant l'étape g).

4. Procédé suivant la revendication 3, dans lequel ledit agent de rinçage est Ar, Ne, Kr, H₂, N₂ ou NH₃.

5. Procédé suivant l'une des revendications 3 ou 4, dans lequel un film protecteur est déposé sur ledit dispositif électrique (28) et ledit ensemble de connexions externes en cadre (29), après ledit nettoyage au plasma et avant ledit enlèvement de la chambre à vide (1).
